**Europäisches Patentamt**

**European Patent Office**

**Office européen des brevets**

(19)

(11) Publication number : **0 373 410 B1**

## EUROPEAN PATENT SPECIFICATION

(12)

(45) Date of publication of patent specification :
25.01.95 Bulletin 95/04

(51) Int. Cl.⁶ : **H03H 17/06, H03H 17/02**

(21) Application number : **89121866.1**

(22) Date of filing : **27.11.89**

(54) **Memory for programmable digital filter.**

(30) Priority : **15.12.88 IT 2295488**

(43) Date of publication of application :
**20.06.90 Bulletin 90/25**

(45) Publication of the grant of the patent :
**25.01.95 Bulletin 95/04**

(84) Designated Contracting States :
**DE FR GB NL**

(56) References cited :
US-A- 4 771 395
ELECTRONIC DESIGN, vol. 35, no. 13, 28th
May 1987, pages 31-36, HasbrouckHeights,
US; D. BURSKY: "Tuned architectures boost
DSP performance"
IEEE TRANSACTIONS ON CIRCUITS AND
SYSTEMS, vol. CAS-32, no. 9, September
1985,pages 893-902, New York, US; D. WIL-
LIAMSON et al.: "An approach to coef-
ficientwordlength reduction in digital filters"
ELECTRONIC ENGINEERING, vol. 58, no. 716,
May 1986, pages 9-10, London, GB; "Inmos - a
new direction for DSP architecture"

(73) Proprietor : **SGS-THOMSON**
**MICROELECTRONICS s.r.l.**
**Via C. Olivetti, 2**
**I-20041 Agrate Brianza (Milano) (IT)**

(72) Inventor : **Cavallotti, Franco**
**105, Via Giosue Borsi**
**I-10100 Torino (IT)**
Inventor : **Cremonesi, Alessandro**
**89, Via Cabrini**
**I-20079 S. Angelo Lodigiano(Milano) (IT)**
Inventor : **Poluzzi, Rinaldo**
**2, Piazza Istria**
**I-20100 Milano (IT)**

(74) Representative : **Forattini, Amelia et al**
**c/o Internazionale Brevetti**
**Ingg. ZINI, MARANESI & C. S.r.l.**
**Piazza Castello 1**
**I-20121 Milano (IT)**

## Description

The present invention relates to a memory for programmable digital filter for wide-band electronic signals, particularly video signals, and more particularly the invention relates to an EPROM memory which can be used to implement a digital filter of the non-recursive type with finite impulse response (FIR) of the kind described in the antedated patent application No. 22890-A/88 in the name of the same Applicant, entitled "Programmable Digital Filter", filed on December 6, 1988.

Said antedated patent relates to a digital filter of the kind with a transposed canonical structure, wherein an array of multipliers provides partial products of the digital signal to be filtered by successive coefficients of the filter's impulse response. The antedated patent replaces said multipliers with tables of pre-calculated partial products contained in one or more re-programmable memories, and each memory cell contains the partial product of an associated stage which corresponds to the value to be processed which coincides with the address of said cell. In particular, said antedated patent uses a single memory which contains, in each line, all the partial products between the address of that line and all the coefficients from $h_0$ to $h_T$, T being the overall number of coefficients of the filter. The line is transmitted in parallel to the arithmetical block of the filter by means of a bank of read amplifiers which are equal in number to the length of the memory line.

However, though the use of a table thus defined instead of multipliers offers advantages in terms of operating speed, simplicity of implementation etc., as the precision of the coefficients of the filter rises, the dimensions of the memory also grow in a linear manner together with the number of read amplifiers, with an increase in silicon area occupation and with a consequent limitation of the performance obtainable from a filter integrated according to a given technology.

A FIR digital filter is known from US-A-4,771,395. The known digital filter also includes tables with previously stored data representative of the product between an input signal and the filter coefficients. However, in a similar manner to the previously described table, the table of US-A-4,771,395 also necessitates a large memory.

Accordingly, the aim of the invention is to provide a programmable digital filter which has the tabular memory architecture described in said antedated patent application, which requires a smaller memory capacity than said prior filter for an equal equivalent output dynamics and with no complications in the circuits associated with the memory. In a typical application, a digital filter according to the present invention provides in output an equivalent dynamics of 20 word bits with a memory size which would allow a dynamics of only 16 bits in said antedated patent application. Together with the reduction in memory size and therefore in the occupied silicon area, the invention also provides an increase in the filter's processing speed (as required, for example, for video applications) for an equal dynamics, or an increase in dynamics with unchanged speed.

The invention achieves the above mentioned aim and other objects and advantages such as will become apparent from the continuation of the description with a programmable digital filter as defined in claim 1.

The invention is now described in greater detail with reference to a preferred embodiment thereof, illustrated in the accompanying drawings and given only by way of non-limitative example, wherein:

figure 1 is a conceptual block circuit diagram of a programmable FIR digital filter according to said antedated patent application;

figure 2 is a plot of the amplitudes of the successive multiplication coefficients from the lowest characteristic to the highest one by which the sampled signal must be multiplied in order to generate the partial products to be added in the arithmetical unit of an FIR filter with transposed canonical structure; and

figure 3 is a detail diagram of the connection between the read amplifier and the adder in a filter according to the invention.

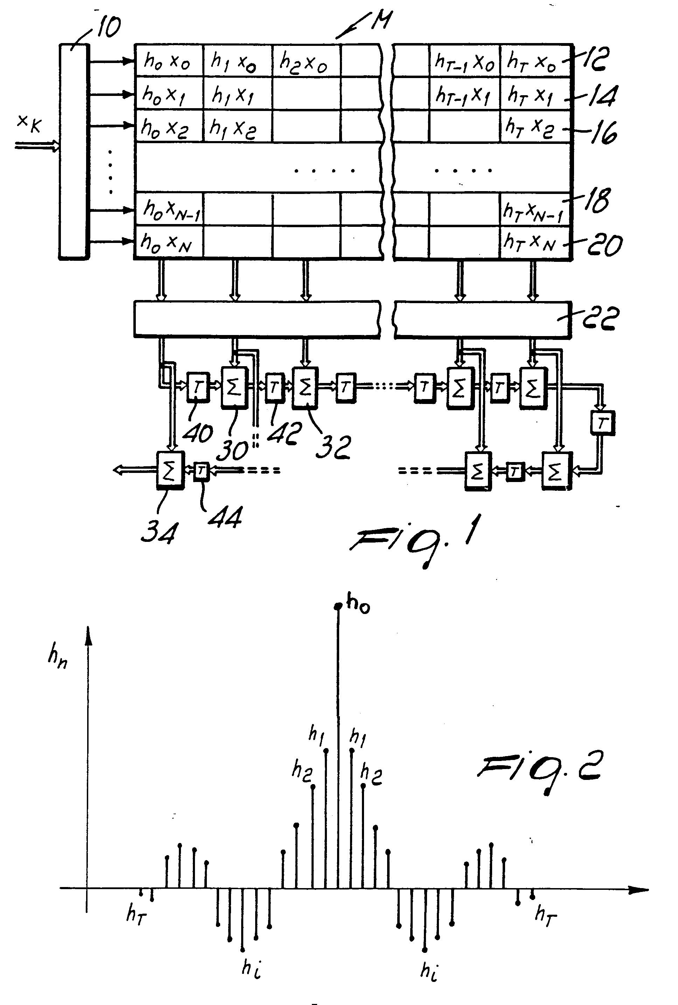

Figure 1 is the block circuit diagram of a digital FIR filter with transposed structure according to the teachings of the above mentioned antedated patent application in the name of the same Applicant, No. 22890-A/88 entitled "Programmable digital filter". The samples $x_k$ of the input signal are fed, with the clock's timing, to a decoder 10 adapted to convert the input word into the selection of one of a plurality of lines 12, 14, 16, ..., 18, 20 of cells of a memory M. The memory has read amplifiers 22 with a number of channels equal to the number of cells which constitute one line; said amplifiers are adapted to allow, in a known manner, the reading of a required memory line.

Each line of cells of the memory M comprises a plurality of one-bit cells which store in succession the products of progressive coefficients $h_0$, $h_1$, $h_2$, ..., $h_T$ for a value which corresponds to the address of said line. Thus, when a sample $x_i$ to be processed is applied to the decoder, the line with address $x_i$ will be excited and the output amplifiers will provide the products $h_0x_i$, $h_1x_i$, $h_2x_i$, ..., $h_Tx_i$.

The outputs of the amplifiers are applied in a known manner to respective first parallel inputs of an array of adders 30, 32, ..., 34, and each adder (starting from the one with lowest characteristic) receives on its second input the output of the preceding adder via a respective delay element 40, 42, ..., 44; all of said delay elements have an identical delay T which is equal to a clock period.

In this manner, the time required to generate each individual partial product is constant and independent from the characteristics of the operands, and is shorter than the time required by the multipliers used in the circuit of figure 1. The products can furthermore be obtained with arbitrary precision, while any rounding or truncation is performed only on the final result.

For a number T of coefficients and an input dynamics of N bits, the filter of the above described kind requires a memory of the following size:

$$2^N \times T \times b,$$

where b is the number of bits assigned to the product of the input datum and the coefficient h of the impulse response. Since the described structure requires the transfer of all said products to the arithmetical unit in parallel, $T \times b$ read amplifier lines, divided into T buses of b lines, are required.

In order to reduce the number of memory cells and therefore the silicon area, as well as the number of read amplifiers, the invention started from the observation that in a typical video filter with a band 0.25-0.50 times the value of the sampling frequency a repetitive decay occurs in passing from one coefficient to the other.

With reference to figure 2, which plots the amplitude of the successive coefficients $h_i$ of i-th impulse response, the following decay can be observed starting from the central coefficient $h_0$:

a) $h_1/h_0 < 0.5$

b) $h_{i+1}/h_i < 0.7$ (for $i > 0$)

This means that the binary representation of the coefficient loses one significant bit for every 2 increment coefficients in the sequence $h_0$, $h_1$, $h_2$, ..., $h_T$ for $i > 0$.

According to the invention, a filter is thus provided which still has the same basic architecture as figure 1 but has successive partial products in each line contained in variable-length words, i.e.:

a number $b_0$ of bits for the central coefficient;

a number $b_0-1$ of bits for the coefficients $h_1$ and $h_2$;

a number $b_0-2$ of bits for the coefficients $h_3$ and $h_4$;

... a number $b_0-T/2$ of bits for the last coefficient (where T/2 is rounded down to the nearest integer if T is odd).

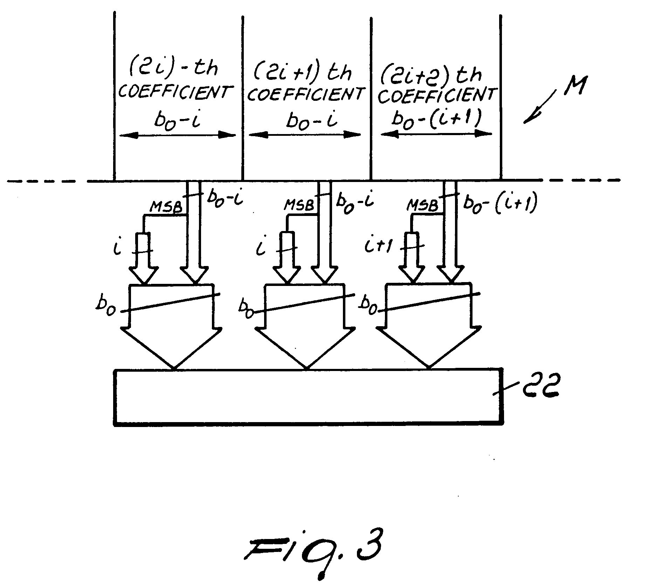

Since the circuits which are external to the memory (adders, delay elements, and the other registers) assume words of uniform length, it is then necessary to expand the shortened words upon their exit from the memory, inserting the bits which had been eliminated therefrom. Choosing a two's-complement representation of the partial products, it is sufficient to replicate the most significant bit of the word as many times as is required to return the word to the standard length, as illustrated in the partial diagram of figure 3.

The number of total non-zero bits required is:

$$N_b = b_0 + 2(b_0 - 1) + 2(b_0 - 2) + ... + 2(b_0 - T/2)$$

where $b_0$ is the precision of the central coefficient. This relationship is reduced to

$$N_b = b_0 T - T^2/4.$$

This means that if the words are stored with variable lengths, eliminating the redundant bits, a saving of $T^2/4$ one-bit cells for each line is achieved, giving a total of $2^N \times T^2/4$ on the entire memory of $2^N$ lines. A number $T^2/4$ of read amplifiers is also saved.

In a typical application with 16 coefficients, 20-bit dynamics and with N = 8, the total memory required is, according to the given equations:

$$2^N (b_0 T - T^2/4) = 65536 \text{ bits}$$

with a saving of 16384 bits with respect to a standard memorization which would require 81920 bits, therefore with a saving of approximately 25%. The saving of 64 amplifier units (320 to 256) must also be added to this.

It can thus be seen that it is possible to achieve a performance which corresponds to 20-bit arithmetics using a memory with an average length of 16 bits with a consequent reduction in area and dissipation.

Though the above described calculations are based on the assumption of an even number of coefficients, the saving would be of the same order even with an odd number of coefficients.

The concepts of the invention may furthermore be also applied to all the other embodiments of the filter as described in said antedated patent application, such as symmetrical ones with or without central coefficient, asymmetrical ones, etc.

The invention is applicable equally well to filters using EPROM, RAM or any other kind of memory.

Where technical features mentioned in any claim are followed by reference signs, those reference signs have been included just for the sole purpose of increasing intelligibility of the claim and accordingly, such reference signs do not have any limiting effect on the scope of the claim.

**Claims**

1. Programmable digital filter comprising an arithmetical chain of parallel adders (30,32,34) alternated with delay elements (40,42,44), and a memory (M) constituted by a plurality of lines (12,14,16,18,20) of a plurality of one-bit cells, each being addressable by a decoder (10) controlled by a digital signal to be filtered, each line (12,14,16,18,20) of memory (M) containing side by side values corresponding to the results of respective partial products of successive impulse response coefficients ($h_i$) with the instantaneous value of a sampled input signal ($x_k$) corresponding to the line address, said memory (M) furthermore comprising a number of read amplifiers (22) equal to the number of cells of one line to read the bits of the addressed line, the outputs of said amplifiers (22) being connected to respective parallel inputs of said adders (30,32,34) of said arithmetical chain, <u>characterized in that</u> each memory line (12,14,16,18,20) contains said values in two's-complement binary form in words which decrease in length by one bit for every increment of 2 in the index of said coefficients ($h_i$) starting from the one with lowest index, and in that the output of each read amplifier (22) corresponding to the most significant bit of each value is connected to a corresponding input bit of the associated adder and also to all input bits of the same adder which are more significant that said corresponding input bit.

**Patentansprüche**

1.  Programmierbares Digitalfilter mit einer arithmetischen Kette von parallelen Addierern (30,32,34) im Wechsel mit Verzögerungselementen (40,42,44) und einem Speicher (M), der durch eine Vielzahl von Leitungen (12,14,16,18,20) aus einer Vielzahl von Einbit Zellen gebildet ist, deren jede durch einen Dekoder (10) adressierbar ist, der durch ein zu filterndes Digitalsignal gesteuert ist, wobei jede Leitung (12,14,16,18,20) des Speichers (M) nebeneinander Werte enthält, die den Ergebnissen zugehöriger Teilprodukte aufeinanderfolgender Impulsansprech-Koeffizienten ($h_i$) mit dem Augenblickswert eines der entsprechend der Leitungsadresse abgetasteten Eingabsignals ($x_k$) entsprechen, wobei der Speicher (M) weiterhin eine der Anzahl der Zellen einer Leitung entsprechende Anzahl von Leseverstärkern (22) enthält, um die Bits der adressierten Leitung zu lesen, und wobei die Ausgänge der Verstärker (22) mit entsprechend parallelen Eingängen der Addierer (30,32,34) der arithmetischen Kette verbunden sind, dadurch gekennzeichnet, daß jede Speicherleitung (12,14,16,18,20) die Werte in binärer Zweierkomplementform in Worten enthält, die in der Länge um ein Bit für jedes Inkrement von 2 im Index der Koeffizienten ($h_i$) abnehmen, beginnend bei dem mit dem niedrigsten Index, und daß der dem höchstwertigen Bit eines jeden Wertes entsprechende Ausgang jedes Leseverstärkers (22) mit einem entsprechenden Eingangsbit des zugeordneten Addierers und auch mit allen Eingangsbits desselben Addierers verbunden ist, die höherwertig als das entsprechende Eingangsbit sind.

**Revendications**

1.  Filtre numérique programmable comprenant une chaîne arithmétique d'additionneurs en parallèle (30, 32, 34) alternés avec des éléments de retard (40, 42, 44) et une mémoire (M) comportant une pluralité de lignes (12, 14, 16, 18, 20) d'une pluralité de cellules de un bit dont chacune est adressable par un décodeur (10) commandé par un signal numérique filtré, chaque ligne (12, 14, 16, 18, 20) de la mémoire (M) contenant des valeurs côte à côte correspondant au résultat des produits partiels respectifs de coefficients de réponse impulsionnels successifs ($h_i$) par la valeur instantanée d'un signal d'entrée échantillonné ($x_k$) correspondant à l'adresse de la ligne, la mémoire (M) comprenant en outre un nombre d'amplificateurs de lecture (22) égal au nombre de cellules d'une ligne pour lire les bits de la ligne adressée, les sorties des amplificateurs (22) étant connectées aux entrées respectives en parallèle des additionneurs (30, 32, 34) de la chaîne arithmétique,
caractérisé en ce que chaque ligne de mémoire (12, 14, 16, 18, 20) contient lesdites valeurs sous forme binaire de compléments à deux dans des mots qui décroissent en longueur d'un bit pour chaque incrément de 2 de l'indice des coefficients ($h_i$) en partant de celui qui a l'indice le plus faible, et en ce que la sortie de chaque amplificateur de lecture (22) correspondant au bit le plus significatif de chaque valeur est connectée à un bit d'entrée correspondant de l'additionneur associé et également à tous les bits d'entrée du même additionneur qui sont plus significatifs que le bit d'entrée correspondant.

Fig. 1

Fig. 2

*Fig. 3*